# EUROPEAN PATENT SPECIFICATION

(11) **EP 2 219 862 B1**
(45) Date of publication and mention of the grant of the patent: **29.06.2016**
(21) Application number: 08860007.7
(22) Date of filing: 05.12.2008
(51) Int. Cl.: B32B 17/10, H05B 33/26, G02F 1/15, G02F 1/153, G02F 1/1345

(54) **MULTILAYER ELEMENT COMPRISING A FUNCTIONAL LAYER HAVING ELECTRICALLY VARIABLE OPTICAL PROPERTIES**
MEHRSCHICHTIGES ELEMENT MIT EINER FUNKTIONELLEN SCHICHT MIT ELEKTRISCH VARIABLEN OPTISCHEN EIGENSCHAFTEN
ÉLÉMENT MULTICOUCHE COMPRENANT UNE COUCHE FONCTIONNELLE DOTÉE DE PROPRIÉTÉS OPTIQUES ÉLECTRIQUEMENT VARIABLES

(30) Priority: 10.12.2007 DE 102007059647; 18.01.2008 DE 102008004942
(43) Date of publication of application: 25.08.2010
(73) Proprietor: Saint-Gobain Glass France, 92400 Courbevoie (FR)
(72) Inventor: ZIEGLER, Stefan, 52074 Aachen (DE); RATEICZAK, Mitja, 52146 Würselen (DE); ALSCHINGER, Matthias, 52134 Herzogenrath (DE)
(74) Representative: Lendvai, Tomas
(86) International application number: PCT/EP2008/010321
(87) International publication number: WO 2009/074266

(56) References cited:
- WO-A-2007/045786
- DE-A1- 10 255 199
- US-A- 4 645 970
- US-A- 5 793 518
- US-A1- 2005 073 851
- US-A1- 2006 152 137
- US-B1- 6 747 779

## Description

The invention relates to a multilayer element comprising a first transparent surface electrode, a functional layer and a planar rear electrode, the first transparent surface electrode projecting laterally beyond the functional layer and the rear electrode and, in a region projecting laterally beyond the rear electrode, being provided with a connection element for feeding in voltage. In this case, a functional layer within the meaning of the present application should be understood as an electroluminescent luminous layer or an electrochromic layer or a liquid-crystal-containing layer, for example. With the aid of the functional layer, the transmission properties or the light emission of the element or the light scattering performed by the element can thus be influenced with influence of the electric field existing between the transparent surface electrode and the planar rear electrode. The electroluminescent luminous layers can be either those on an inorganic basis or those on an organic basis (OLED).

The present invention relates further to an electrochemical and/or electrically controllable device of the glazing type which has variable optical and/or energetic properties.

There is an increased demand for so-called "intelligent" glazing which can adapt to the users' requirements. This may involve controlling the delivery of sunlight through glazing fitted on the exterior or buildings or vehicles such as automobiles, trains or aircraft, for example a window. The purpose is to be able to limit excessive heating inside the rooms/cockpits, but only in case of strong sunshine.

It may also involve controlling the degree of vision through glazing, particularly in order to darken it, render it diffusing or prevent any vision when so desired. This may relate to glazing fitted as interior partitions inside rooms, trains, aircraft or fitted as automobile side windows. It also relates to mirrors used as wing mirrors, in order to avoid the driver being locally dazzled, or signaling panels so that messages appear when this is necessary or intermittently in order to attract attention better. Glazing, which can be rendered diffusing at will, may be used when so desired as projection screens.

As a variation, it may involve generation of light by the glazing in order to control the level of luminosity or the color generated. There are various electrically controllable systems allowing these types of aspect/thermal property modifications. In order to modulate the optical transmission or optical absorption by glazing, there are so-called viologen systems such as those described in Patents US-5 239 406A and EP-612 826 A2.

US 4,645,970 A discloses a decorative panel assembly for vehicles or other applications including illuminated indicia, insignia or designs together with at least one transparent area in one of two panels.

US 2006/0152137 A1 discloses an electrically controllable device having a variable optical and/or energy properties or electroluminescent device. The device comprises a carrier substrate carrying an electroactive multilayer stack between an upper and lower electrode.

WO 2007/045786 A1 discloses a lighting structure comprising at least one light-emitting diode. The LED lightning structure comprises a first dielectric element with a first electrode, a second dielectric element with a second electrode and a first light-emitting-diode.

In order to modulate the optical transmission and/or thermal transmission of glazing, there are also so-called electrochromic systems. As is known, these generally comprise two electrochromic material layers separated by an electrolyte layer and framed by two electrically conductive layers, the latter being associated with current feeds connected to an electricity supply. Each of these electrochromic material layers can reversibly insert cations and electrons, the modification of their oxidation state due to these insertions/deinsertions leading to a change in its optical and/or thermal properties. In particular, their absorption and/or their reflection at visible and/or infrared wavelengths can be modified.

It is common to divide electrochromic systems into the following categories:
- that in which the electrolyte is in the form of a polymer or a gel; for example, a polymer with protonic conduction such as those described in Patents EP-253 713 A2 or EP-670 346 A2, or a polymer with lithium ion conduction such as those described in Patents EP-382 623, EP-518 754 A2 and EP-532 408 A2; the other layers of the system are generally of inorganic nature,
- that in which the electrolyte is an inorganic layer. This category is often referred to by the term "all solid" system, and examples of it can be found in Patents EP-867 752 A2, EP-831 360 A2, Patents WO 00/57243 A2 and WO 00/71777 A2.
- that in which all the layers are based on polymers, which category is often referred to by the term "all polymer" system.

The former layers are operated with AC voltage, whereas in the case of the latter layers a DC voltage is applied between the transparent surface electrode and the rear electrode.

Multilayer elements of this type have already been generally known for a relatively long time e.g. in the form that the functional layer is an electroluminescence luminous element. In order to obtain a highest possible luminous intensity of the electroluminescence luminous element, a highest possible optical transmissivity of the surface electrode in the wavelength range of interest is required. The surface electrode is ascribed in principle to the layers of the functional element and usually forms the interface between a carrier substrate (e.g. glass, film, Plexiglas, etc.) and the actual functional element in the narrower sense.

The electroluminescence luminous element can be produced for example by screen printing or by way of so-called thin-film technology. In the case of screen printing, firstly e.g. the substrate is coated with the transparent electrode by sputtering, whereupon the luminous layer is then applied. The electroluminescence luminous elements produced by way of thin-film technology have the advantage of a very high thermal stability, such that the panes of glass often used as a substrate can also be provided with the electroluminescence luminous layer before they are actually bent and/or prestressed.

The contact-connection and voltage supply of the two electrodes may be regarded as problematic in the case of the known multilayer elements: while contact-connection is unproblematic in the region of the rear electrode, which is generally non-transparent and composed of silver screen printing paste, for example, leading out a connecting conductor e.g. in the form of a thin wire from the rear electrode as far as the edge of the substrate in which the transparent surface electrode is contact-connected is difficult from optical standpoints.

Since the electroluminescence luminous elements often have very specific geometries or shapes and are surrounded on all sides by clear glass, for example, the electrical conductor led through the clear glass region is conspicuous in an undesirable manner.

### Object

The invention is based on the object of proposing a multilayer element in which the contact-connection and voltage supply do not appear visually even in the case of a transparent substrate surrounding the functional layer.

### Achieving the object

Proceeding from a multilayer element of the type described in the introduction, this object is achieved according to the invention by means of a second transparent surface electrode, which projects laterally beyond the rear electrode and which is connected by means of a dielectric adhesive layer firstly to the rear electrode and, in a region projecting beyond the rear electrode, secondly to the first transparent surface electrode, a contact element that penetrates through the dielectric transparent adhesive layer being arranged between the rear electrode and the second transparent surface electrode, said contact element electrically conductively connecting the rear electrode and the second transparent surface electrode to one another at least indirectly.

A voltage supply of the functional layer that is totally invisible in the edge regions around the functional layer is provided in this way. The two transparent surface electrodes are connected by the transparent dielectric adhesive layer alongside the functional layer. The actual functional layer is therefore surrounded on all sides by an invisible two-pole supply line, such that its contours are discernible completely freely and without a conductor wire issuing therefrom, for example, as is customary in the prior art. The contact-connection of the functional layer is effected at any desired location thereof with the aid of the at least one contact element that penetrates through the transparent dielectric adhesive layer and thus in one embodiment forms a direct electrical connection between the second transparent surface electrode and the rear electrode.

Since the rear electrode is not visible, the contact element can be arranged at any desired location within the contour lines of the rear electrode and as such be readily visible. Other layers can also be arranged as required between the transparent dielectric adhesive layer and the second transparent surface electrode, as long as at least an indirect electrical connection to the rear electrode is formed, such that an electric field that is high enough to activate the functional layer, that is to say excite it to light emission, for example, can be built up between said rear electrode and the first transparent surface electrode.

In one variant of the multilayer element according to the invention, the contact element electrically couples the rear electrode to the second transparent surface electrode. By way of example, a multilayer element that emits in one direction can be provided in this way.

There are situated on both sides of the dielectric transparent adhesive layer in each case firstly a rear electrode and then a functional layer and, adjoining the latter, a transparent surface electrode, the contact element electrically connecting the two rear electrodes to one another. A construction that is mirror-symmetrical with respect to the central plane of the dielectric transparent adhesive layer is obtained in this way, such that the multilayer element, in the case of a respective electroluminescent luminous layer as functional element, emits light in both opposite directions in each case perpendicular to the electroluminescence luminous elements. In this case, the electroluminescence luminous elements lying opposite one another can be congruent, but can also overlap one another only partly, such that, as viewed from at least one side of the multilayer element (rear) regions of the electroluminescence luminous element arranged on the other side are visible, but they cannot emit in the direction of the observer and therefore from their "rear side", only prevent the view through the multilayer element.

It is likewise conceivable for two different functional layers to be used in the same multilayer element, thus e.g. a luminous layer and an electrochromic layer.

In accordance with a particularly preferred embodiment of the multilayer element according to the invention, the first transparent surface electrode and/or the second transparent surface electrode are/is applied to a substrate, the substrate(s) in each case forming an outer layer of the multilayer element. The substrates serve firstly as a mechanical protective layer for the respective surface electrode and secondly also as an insulator for the transparent surface electrodes, in order to avoid the risk of an electric shock for persons.

This is not unimportant, since the supply voltages of electroluminescence luminous elements can extend into ranges significantly above 100 volts.

If the substrate is a flexible film, then the multilayer element overall after its production can be laminated onto any desired - rigid or flexible-carrier material. If the substrate is a "rigid" material such as glass, for example, then in the case of transparent surface electrodes on a thin-film basis, the finished multilayer element can be bent or prestressed by thermal treatment.

Appropriate transparent plastic materials include, in particular, polycarbonate (Plexiglas) or transparent films such as, for example, those composed of polyethylene terephthalate (PET). Typically, the multilayer element has an area of greater than 10 cm², preferably greater than 100 cm², particularly preferably greater than 1000 cm², and especially preferably greater than 10000 cm².

In order to keep the operating voltage of the electroluminescence luminous element as low as possible, an insulator layer, preferably composed of barium titanate (BaTiO₃), should be situated between the at least one electroluminescence luminous element and the assigned rear electrode. Layers of this type have proved to be very worthwhile in the case of electroluminescence luminous elements on account of their high dielectric constant.

In a further configuration of the invention it is provided that the contact element is arranged with prestress in the dielectric adhesive layer of the multilayer element and, in the finished state of the multilayer element, presses elastically against the two layers to be electrically contact-connected. The prestress permanently present increases the contact reliability and can thus provide for reliable operation even under operating conditions made more difficult (mechanical stress, changing use temperatures and expansions/contractions caused thereby). In accordance with one configuration of the contact element, the latter can be a metal clip bent in C-shaped fashion, preferably composed of wire or sheet metal. Furthermore, it is also possible, however, for the contact element to be a braided wire structure which, as in the case of the C-shape as well, has an elasticity inherent to the geometry of the structure. Furthermore, one option also consists in the fact that the contact element has an elastic core, e.g. composed of a foam material, and a conductive flexible sheath surrounding said core. A material of this type is available as strip material, for example, such that the individual contact elements are produced in the form of sections of this strip and are inserted into prefabricated perforations in the transparent dielectric adhesive layer during the production process for the multilayer element.

Furthermore, one variant in the possible embodiment of the contact element also consists in the fact that the latter is formed by an electrically conductive adhesive or by conductive silver lacquer, the adhesive or the conductive silver lacquer being introduced in a liquid state in a perforation in the dielectric transparent adhesive layer and, in the finished state of the multilayer element, being cured and cohesively connected to the layers to be electrically connected.

According to one configuration of the invention it is furthermore provided that the contact element is transparent and preferably comprises a transparent polymer. In this case, even the typically very small contact element in terms of its extent does not appear undesirably within the functional layer. In particular, the contact element can be embodied in the form of a film that is composed of transparent polymer and is provided, preferably stitched, with very thin conductive wires. As an alternative, however, the contact element can also be composed of a transparent polymer with electrically conductive particles, preferably nanoparticles, situated therein.

In accordance with an optically particularly advantageous development of the multilayer element according to the invention, this element is transparent overall at least in a non-activated state of the functional element. Upon activation of the functional element by the application of a voltage between the two surface electrodes, for the observer this results in the surprising effect that "out of nothing" a specific region of the multilayer element that is formed by the functional layer or the functional layers e.g. starts to emit light or becomes non-transparent and in the process "floats" in the multilayer element in a manner apparently "without foundation", i.e. apparently without any connections, from the observer's point of view.

The invention is explained in more detail below on the basis of two exemplary embodiments of a multilayer element comprising an electroluminescence luminous element which is illustrated schematically in the drawings.

In the figures:
Figure 1 shows a cross section through a first embodiment of a multilayer element with light emission on one side,
Figure 2 shows a cross section through a second embodiment of a multilayer element with light emission on both sides, and
Figure 3 shows a partial cross section through the multilayer element in accordance with Figure 1 with illustration of two alternative contact elements.

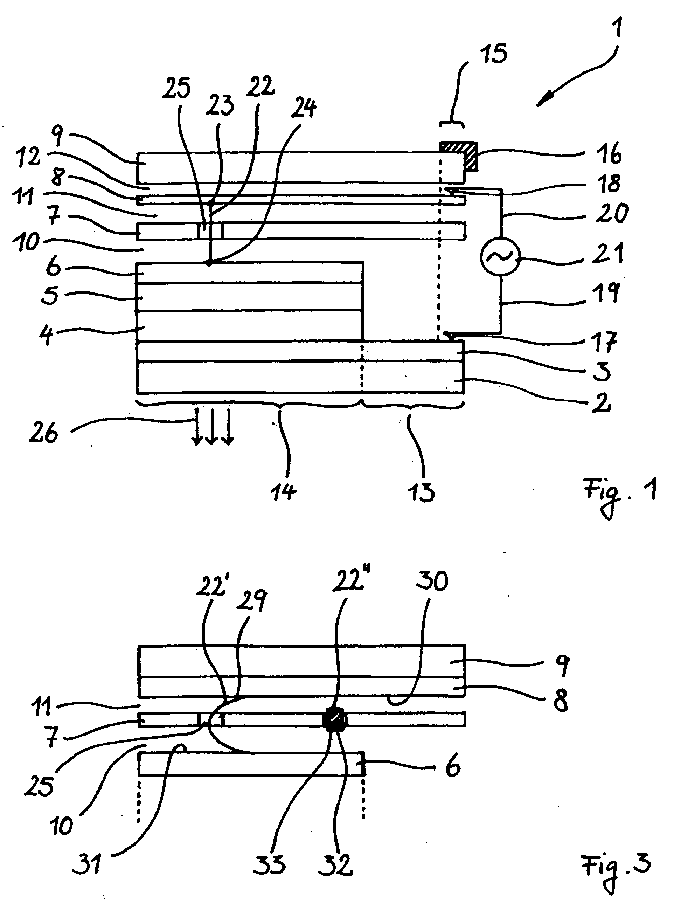

A multilayer element 1 illustrated schematically and not to scale with regard to the thickness relations in Figure 1 comprises a first substrate 2 in the form of a float glass pane having a high transmission coefficient. On the substrate 2 there is a transparent surface electrode 3 in the form of a thin-film system with the following sequence of layers (proceeding from the substrate 2): Si₃N₄-ZnO-Ti/Ag-ZnO-Si₃N₄-ZnO-Ti-Ag-ZnO-Si₃N₄. Such a highly temperature-resistant transparent thin-film system and its production are known from DE 102 55 199 A1, for example. The substrate 2 together with the surface electrode 3 can be subjected to a thermal bending process without the conductivity properties of the surface electrode 3 being adversely affected.
Situated above the transparent surface electrode 3 is an electroluminescence luminous element 4 which is known from the prior art and which forms the functional layer and which is followed further towards the top by an insulator layer 5 composed of barium titanate (BaTiO₃). This latter insulator layer 5 is followed by a rear electrode 6, which is composed of silver paste and is therefore non-transparent. As a succeeding layer the multilayer element has a dielectric adhesive layer 7 in the form of a known PVB film that is used for connecting the individual glass panes in the case of laminated glass panes. The last two layers of the multilayer element 1 are then formed by a second transparent surface electrode 8 and a second substrate 9, likewise in the form of a float glass pane. The free spaces 10, 11 and 12 depicted in Figure 1 for the sake of clarity are, of course, not present in the finished multilayer element 1 and serve solely for better discernibility. The second transparent surface electrode 8 which is constructed identically to the first transparent surface electrode 3, is applied to the second substrate 9 and connected thereto by way of a thin-film method. The connection of the first substrate 2 with the "layers" 3 to 6 situated thereon and the second substrate 9 with the surface electrode 8 situated thereon are permanently connected to one another with the action of heat and melting of the PVB film forming the adhesive layer 7.

Both the first substrate 2 with the first surface electrode 3 and the second substrate 9 with the second surface electrode 8 situated thereon and also the adhesive layer 7 project laterally beyond the "subassembly" formed from the electroluminescence luminous element 4, the insulator layer 5 and the rear electrode 6. In this laterally projecting region 13, the first transparent surface electrode 3 is directly connected to the adhesive layer 7 in the finished state of the multilayer element 1. On account of the very small thicknesses of the "subassembly" comprising the "layers" 4, 5 and 6, its absence in the region 13 is not conspicuous. Appreciable bending stresses in the float glass panes forming the first and the second substrate 2 and 9 do not arise. In the region 14 formed by the electroluminescence luminous element 4, the insulator layer 5 and the rear electrode 6, the multilayer element 1 is not transparent on account of the absent transparency of the insulator layer 5 and the rear electrode 6. In contrast thereto, only transparent layers (substrates 2 and 9, surface electrodes 3 and 8 and adhesive layer 7) are present in the projecting region 13.

Furthermore, the multilayer element 1 has an edge region 15 covered opaquely by a non-transparent covering element 16. Situated within the edge region 15 are a first connection element 17 (e.g. in the form of a known flat conductor), which is electrically conductively connected to the first surface electrode 3, and a second connection element 18, which is electrically conductively connected to the second surface electrode 8. A supply line 19, 20 respectively issues from the connection elements 17, 18 and leads to an AC voltage source 21.

Finally, a contact element 22 is additionally shown only schematically in the illustration, said contact element being electrically conductively in contact with the second transparent surface electrode 8 at a point 23, and with the rear electrode 6 by a point 24. The contact element 22 is led through a perforation 25 in the adhesive layer 7 in order to supply the rear electrode 6 with voltage from the AC voltage source 21. The perforation 25 in the adhesive layer 7, formed by a PVB film, is typically produced by means of a simple stamping-out process.

In the finished state of the multilayer element 1 as well, in which the contact element 22 is deformed relative to the initial state, there is, of course, at the points 23 and 24 an electrically conductive connection between the contact element 22 and the surface electrode 8, and respectively the rear electrode 6.

If the AC voltage source 21 is active, then an alternating electric field forms between a capacitor formed by the rear electrode 6 and the first surface electrode 3, said field being additionally increased by the insulator layer 5 composed of a material having a high dielectric constant. By virtue of the supply voltage that is chosen to be appropriately high, the electric field is strong enough to excite the electroluminescence luminous element 4 to light emission. On account of the opaqueness of the insulator layer 5 and the rear electrode 6 to the emitted light, emission takes place only through the surface electrode 3 and the first substrate 2 in the direction of the arrows 26.

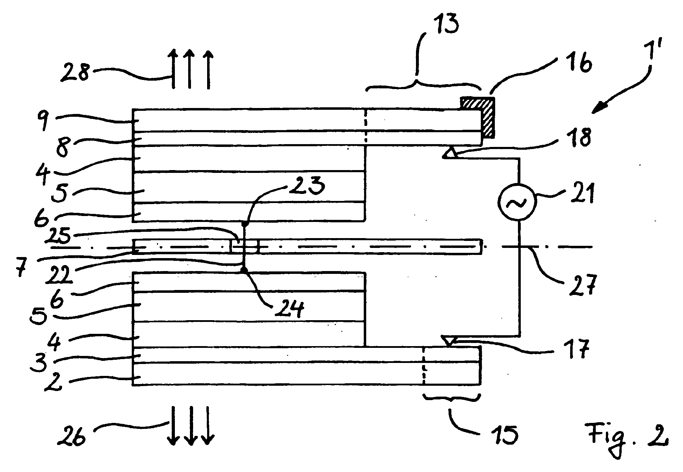

The multilayer element 1' shown in Figure 2 is symmetrical in its construction with respect to a central plane 27 of an adhesive layer 7 likewise formed by a PVB film. The following layer construction is present in both directions proceeding from the adhesive layer 7: rear electrode 6, insulator layer 5, electroluminescence luminous element 4. While the first transparent surface electrode 3 is situated in the lower region of the multilayer element 1', the second transparent surface electrode 8 is situated at the mirrored position in the upper half.

The multilayer element 1' is terminated towards the top and bottom by respectively a first substrate 2 and second substrate 9, in each case in the form of a float glass pane. In the multilayer element 1' as well, two connecting elements 17 and 18 are situated at the first surface electrode 3 and the second surface electrode 8, respectively. With the aid of a contact element 22, which is led through a perforation 25 in the adhesive layer 7 and is electrically conductively connected at points 23 and 24 to the upper and the lower rear electrode 6, respectively, the two rear electrodes 6 are brought to the same electrical potential. Consequently, the multilayer element 1' contains a series circuit of two capacitors which are respectively formed between the first surface electrode 3 and the facing rear electrode 6 and between the further rear electrode 6 and the second surface electrode 8.

Situated between the two capacitor electrodes is in each case an electroluminescence luminous element 4 at the same time and an insulator layer 5. In the present case, the voltage generated by the AC voltage source 21 must be high enough that it excites the two electroluminescence luminous elements 4 to light emission. While the radiation emitted by the lower electroluminescence luminous element 4 is emitted in the direction of the arrows 26, the upper electroluminescence luminous element 4 emits in the direction of the opposite arrows 28.

As also in the case of the multilayer element 1 shown in Figure 1, the multilayer element 1' in accordance with Figure 2 also has a region 13 in which in each case the first and respectively second surface electrode 3, 8 and also the first and respectively the second substrate 2, 9 and also furthermore the adhesive layer 7 project laterally beyond the rest of the layers. All of the projecting layers mentioned above are transparent and, consequently, no supply lines to the luminous element whatsoever are visible. The connection elements 17, 18 are situated in the edge region 15 that is invisibly concealed by means of the covering element. The connection elements 17, 18 can be for example flat conductors which are known according to the prior art and which are arranged in the region of the adhesive layer 7 and from which the supply lines 19, 20 are led to the AC voltage source 21. Figure 3 illustrates two alternative embodiments of a contact element 22' and 22".

Both contact elements 22' and 22" in each case connect a second transparent surface electrode 8 applied to a second substrate 9 to a rear electrode 6 and in each case extend through a perforation 25 in an adhesive layer 7 in the form of PVB film. For the sake of simplicity, the layers arranged below the rear electrode 6 (insulator layer composed of barium titanate and electroluminescence luminous element and also first surface electrode and first substrate), have been omitted. In this respect, the construction of the multilayer element shown in figure 3 corresponds to that of the multilayer element 1 in accordance with Figure 1.

The first contact element 22' arranged on the left in Figure 3 is a wire clip bent in C-shaped fashion or a sheet metal strip bent in C-shaped fashion. On account of its prestress, which is manifested particularly when the layer element in the finished state no longer has the free spaces 10 and 11 illustrated in the drawing, legs 29 of the contact element 22' bear under pressure against the surface 30 of the second surface electrode 8 facing the adhesive layer 7 and ensure reliable contact-connection in this way. The same applies to the opposite lower leg 29 and the surface 31 of the rear electrode 6 that is assigned to it. On account of the adhesive layer 7 present in the melted state when the individual assemblies of the layer element are joined together, the contact element 22' can press at least partly into the adhesive layer 7, such that there is a space problem during the joining-together process.

The alternative contact element 22' has a core 32 in the form of a plastic foam material. The core 32 is enveloped by a sheath 33, for example composed of a wire braiding. The sheath 33 does not have to extend over the entire circumference or the entire outer surface of the core, which can be embodied e.g. in a cylindrical fashion or else in parallelepipedal fashion. The production of the contact elements 22" is particularly efficient when they are produced as sections from a continuous strip. All that is essential is that an electrically conductive connection in the form of wires is always present between the opposite sides facing the surface electrode 8, on the one hand, and the rear electrode 6, on the other hand, and that secondly the contact element 22', proceeding from the initial position which is illustrated in Figure 3 and in which its thickness is slightly larger than the thickness of the adhesive layer 7, is elastically reduced to the reduced thickness of the adhesive layer 7, such that restoring forces remain in the finished state of the multilayer element and provide for reliable contact-connection even under conditions made more difficult (thermal expansions, vibrations, etc.).

The invention is further explained in more detail below on the basis of two exemplary embodiments of a multilayer element comprising an electrochromic system which is explained below.

An electrochromic system comprising a transparent electrically conducting film, a film of a cathodic electrochromic material, which is capable of reversibly inserting M⁺ cations of the type H⁺ or Li⁺, a lithium or proton conducting electrolyte film, counter-electrode film made of an anodic electrochromic material, and a second electrically conducting film, said structure having a barrier film interposed between electrolyte and the counter-electrode , said barrier film permitting the diffusion of the M⁺ cations and which is a substance selected from the group consisting of Nb₂O₅, CeF₃, Sb₂O₃, HUP, Cr₂O₃, ZrO₂, Li₃N, LiTaO₃, LiAlF₄, Li₃PO₄, LiBO₂ and LiNbO₃.

The barrier film of the electrochromic system is preferably transparent. The barrier film is resistant in acid medium (M⁺ = H⁺) or in neutral medium (M⁺ = Li⁺). The barrier film is a filter to ion or gaseous species transported in the while being open to the diffusion of M⁺ cations. The barrier film is of a material which increases the overvoltage of reducing agents at the interface between the electrolyte and the counter-electrode. The said barrier film is made of an electron insulating material. The barrier film has a thickness of from 1 to 500 nanometers. The barrier film thickness ranges from 20 to 120 nanometers.

The electrolyte of the electrochromic system is a proton-conducting material, the counter-electrode is based upon iridium oxide of the HₓIrO_{y}, type or based upon nickel oxide of the HₓNiO_{y} type. The electrochromic system according to claim 1, wherein the electrolyte is a lithium-conducting material, and the counter-electrode is based upon nickel oxide of the type Liₓ NiO_{y}.

The electrochromic system comprises further a second barrier film interposed between the film of cathodic electrochromic material and the electrolyte. The barrier film is one of said ion conductors in the instance where M⁺ = Li⁺.

The the electrically conducting films of the electrochromic system are of tin oxide doped with fluorine (SnO₂:F) or of indium oxide doped with tin (ITO). The electrically conductive film is overlain by a film of tin oxide.

The electrochromic system comprises a transparent electrically conducting film, a film of a cathodic electrochromic material, which is capable of reversibly inserting M⁺ cations of the type H⁺ or Li⁺, a lithium or proton conducting, electrolyte film, counter-electrode film made of an anodic electrochromic material, and a second electrically conducting film, said structure having a barrier film interposed between electrolyte and the counter-electrode, said barrier film permitting the diffusion of the M⁺ cations and which is a Ta₂O₅ layer having a thickness ranging from 1 to 500 nm and which is preferably a Ta₂O₅ layer having a thickness ranging from 40 to 120 nm.

### List of reference symbols

1, 1' Multilayer element
2 First substrate
3 First surface electrode
4 Functional layer
5 Insulator layer
6 Rear electrode
7 Adhesive layer
8 Second surface electrode
9 Second substrate
10, 11, 12 Free space
13, 14 Region
15 Edge region
16 Covering element
17, 18 Connection element
19, 20 Supply line
21 AC voltage source
22, 22', 22" Contact element
23, 24 Point
25 Perforation
26 Arrow
27 Central plane
28 Arrow
29 Leg
30, 31 Surface
32 Core
33 Sheath

## Claims

1. Multilayer element (1, 1') comprising a first transparent surface electrode (3), a functional layer (4) and a planar rear electrode (6), the first transparent surface electrode (3) projecting laterally beyond the functional layer (4) and the rear electrode (6) and, in a region (13) projecting laterally beyond the rear electrode (6), being provided with a connection element (17) for feeding in voltage, wherein a second transparent surface electrode (8), which projects laterally beyond the rear electrode (6) and which is connected by means of a transparent dielectric adhesive layer (7) firstly to the rear electrode (6) and, in a region (13) projecting beyond the rear electrode (6), secondly to the first transparent surface electrode (3), a contact element (22, 22', 22") that penetrates through the dielectric transparent adhesive layer (7) being arranged between the rear electrode (6) and the second transparent surface electrode (8), said contact element connecting the rear electrode (6) and the second transparent surface electrode (8) to one another at least indirectly **characterized in that** there are situated on both sides of the transparent dielectric adhesive layer (7) in each case firstly a rear electrode (6) and then a functional layer (4) and, adjoining the latter, a first or second transparent surface electrode (3, 8), the contact element (22) electrically connecting the two rear electrodes (6) to one another.

2. Multilayer element according to Claim 1, **characterized in that** the contact element (22, 22', 22") electrically couples the rear electrode (6) to the second transparent surface electrode (8).

3. Multilayer element (1, 1') according to Claim 1 or 2, **characterized in that** the first transparent surface electrode (3) and/or the second transparent surface electrode (8) are/is applied to a substrate (2, 9), the substrate (s) in each case forming an outer layer of the multilayer element (1, 1').

4. Multilayer element (1, 1') according to Claim 3, **characterized in that** at least one substrate is composed of glass or transparent plastic material, in particular of polycarbonate, or a transparent plastic film, in particular polyethylene terephthalate (PET).

5. Multilayer element (1, 1') according to any of Claims 1 to 4, **characterized in that** the functional element (4) is an electroluminescence luminous element, an electrochromic layer or a liquid-crystal-containing layer.

6. Multilayer element (1, 1') according to Claim 5, **characterized in that** an insulator layer (5), preferably composed of barium titanate (Ba-TiO₃), is situated between at least one electroluminescence luminous element and the assigned rear electrode (6).

7. Multilayer element (1, 1') according to any of Claims 1 to 6, **characterized in that** the contact element (22, 22', 22") is arranged with prestress in the dielectric transparent adhesive layer (7) of the multilayer element (1, 1') and, in a finished state of the multilayer element (1, 1'), presses elastically against the two layers to be electrically contact-connected.

8. Multilayer element (1, 1') according to Claim 7, **characterized in that** the contact element (22') is a metal clip bent in C-shaped fashion, preferably composed of wire or sheet metal.

9. Multilayer element (1, 1') according to Claim 7, **characterized in that** the contact element (22") is a braided wire structure.

10. Multilayer element (1, 1') according to Claim 7 to 9, **characterized in that** the contact element (22") has an elastic core (32), e.g. composed of a foam material, and a conductive flexible sheath (33) surrounding said core.

11. Multilayer element (1, 1') according to any of Claims 7 to 10, **characterized in that** the contact element (22) is formed by an electrically conductive adhesive or by conductive silver lacquer, the adhesive or the conductive silver lacquer being introduced in a liquid state in a perforation (25) in the dielectric adhesive layer (7) and, in the finished state of the multilayer element (1, 1'), being cured and cohesively connected to the layers to be electrically connected.

12. Multilayer element (1, 1') according to any of Claims 1 to 11, **characterized in that** the contact element (22) is transparent, and preferably comprises a transparent polymer.

13. Multilayer element (1, 1') according to Claim 12, **characterized in that** a film composed of transparent polymer is provided, preferably stitched, with very thin conductive wires.

14. Multilayer element (1, 1') according to Claim 1 comprising at least one electrically conducting film, a film of a cathodic electrochromic material, which is capable of reversibly inserting M⁺ cations of the type H⁺ or Li⁺, a lithium or proton conducting electrolyte film, counter-electrode film made of an anodic electrochromic material, and a second electrically conducting film, said structure having a barrier film interposed between electrolyte and the counter-electrode , said barrier film permitting the diffusion of the M⁺ cations and which is a substance selected from the group consisting of Nb₂O₅, CeF₃, Sb₂O₃, HUP, Cr₂O₃, ZrO₂, Li₃N, LiTaO₃, LiAlF₄, Li₃PO₄, LiBO₂ and LiNbO₃.

15. Multilayer element (1, 1') according to Claim 1 comprising at least one electrically conducting film, a film of a cathodic electrochromic material, which is capable of reversibly inserting M⁺ cations of the type H⁺ or Li⁺, a lithium or proton conducting, electrolyte film, counter-electrode film made of an anodic electrochromic material, and a second electrically conducting film, said structure having a barrier film interposed between electrolyte and the counter-electrode, said barrier film permitting the diffusion of the M⁺ cations and which is a Ta₂O₅ layer having a thickness ranging from 1 to 500 nm and which is preferably a Ta₂O₅ layer having a thickness ranging from 40 to 120 nm.

## Patentansprüche

1. Mehrschichtelement (1, 1') enthaltend eine erste transparente Flächenelektrode (3), eine Funktionsschicht (4) und eine flächige Rückelektrode (6), wobei die erste transparente Flächenelektrode (3) seitlich über die Funktionsschicht (4) und die Rückelektrode (6) vorsteht und in einem seitlich über die Rückelektrode (6) vorstehenden Bereich (13) mit einem Anschlusselement (17) zur Spannungseinspeisung versehen ist, wobei eine seitlich über die Rückelektrode (6) vorstehende zweite transparente Flächenelektrode (8), die mittels einer transparenten dielektrischen Klebeschicht (7) zum einen mit der Rückelektrode (6) und in einem über die Rückelektrode (6) vorstehenden Bereich (13) zum anderen mit der ersten transparenten Flächenelektrode (3) verbunden ist, wobei zwischen der Rückelektrode (6) und der zweiten transparenten Flächenelektrode (8) ein die dielektrische transparente Klebeschicht (7) durchdringendes Kontaktelement (22, 22', 22") angeordnet ist, wobei das besagte Kontaktelement die Rückelektrode (6) und die zweite transparente Flächenelektrode (8) zumindest mittelbar miteinander verbindet, **dadurch gekennzeichnet, dass** sich beidseitig der transparenten dielektrischen Klebeschicht (7) jeweils zunächst eine Rückelektrode (6) und danach eine Funktionsschicht (4) und an Letztere angrenzend eine erste oder zweite transparente Flächenelektrode (3, 8) befinden, wobei das Kontaktelement (22) die beiden Rückelektroden (6) elektrisch miteinander verbindet.

2. Mehrschichtelement nach Anspruch 1, **dadurch gekennzeichnet, dass** das Kontaktelement (22, 22', 22") die Rückelektrode (6) mit der zweiten transparenten Flächenelektrode (8) elektrisch koppelt.

3. Mehrschichtelement (1, 1') nach Anspruch 1 oder 2, **dadurch gekennzeichnet, dass** die erste transparente Flächenelektrode (3) und/oder die zweite transparente Flächenelektrode (8) auf ein Substrat (2, 9) aufgebracht ist/sind, wobei das oder die Substrat(e) jeweils eine äußere Schicht des Mehrschichtelements (1, 1') bilden.

4. Mehrschichtelement (1, 1') nach Anspruch 3, **dadurch gekennzeichnet, dass** mindestens ein Substrat aus Glas oder transparentem Kunststoffmaterial, insbesondere aus Polycarbonat, oder einer transparenten Kunststofffolie, insbesondere Polyethylenterephthalat (PET), besteht.

5. Mehrschichtelement (1, 1') nach einem der Ansprüche 1 bis 4, **dadurch gekennzeichnet, dass** das Funktionselement (4) ein Eletrolumineszenz-Leuchtelement, eine elektrochrome Schicht oder eine Flüssigkristall enthaltende Schicht ist.

6. Mehrschichtelement (1, 1') nach Anspruch 5, **dadurch gekennzeichnet, dass** sich zwischen mindestens einem Elektrolumineszenz-Leuchtelement und der zugeordneten Rückelektrode (6) eine Isolatorschicht (5), vorzugsweise gebildet aus Bariumtitanat (Ba-Ti03), befindet.

7. Mehrschichtelement (1, 1') nach einem der Ansprüche 1 bis 6, **dadurch gekennzeichnet, dass** das Kontaktelement (22, 22', 22") mit Vorspannung in der dielektrischen transparenten Klebeschicht (7) des Mehrschichtelements (1, 1') angeordnet ist und in einem fertigen Zustand des Mehrschichtelements (1, 1') elastisch gegen die beiden elektrisch zu kontaktierenden Schichten drückt.

8. Mehrschichtelement (1, 1') nach Anspruch 7, **dadurch gekennzeichnet, dass** das Kontaktelement (22') ein C-förmig gebogener Metallbügel, vorzugsweise aus Draht oder Blech, ist.

9. Mehrschichtelement (1, 1') nach Anspruch 7, **dadurch gekennzeichnet, dass** das Kontaktelement (22") eine geflochtene Drahtstruktur ist.

10. Mehrschichtelement (1, 1') nach Anspruch 7 bis 9, **dadurch gekennzeichnet, dass** das Kontaktelement (22") einen elastischen, z.B. aus einem Schaummaterial bestehenden Kern (32) und eine diesen umgebende leitfähige flexible Hülle (33) aufweist.

11. Mehrschichtelement (1, 1') nach einem der Ansprüche 7 bis 10, **dadurch gekennzeichnet, dass** das Kontaktelement (22) von einem elektrisch leitfähigen Klebstoff oder von Silberleitlack gebildet ist, wobei der Klebstoff oder der Silberleitlack in flüssigem Zustand in einem Durchbruch (25) in der dielektrischen Klebeschicht (7) eingebracht wird und im fertigen Zustand des Mehrschichtelements (1, 1') ausgehärtet ist und in stoffschlüssiger Verbindung mit den elektrisch zu verbindenden Schichten steht.

12. Mehrschichtelement (1, 1') nach einem der Ansprüche 1 bis 11, **dadurch gekennzeichnet, dass** das Kontaktelement (22) transparent ist, vorzugsweise ein transparentes Polymer aufweist.

13. Mehrschichtelement (1, 1') nach Anspruch 12, **dadurch gekennzeichnet, dass** eine aus transparentem Polymer bestehende Folie mit sehr dünnen leitfähigen Drähten versehen, vorzugsweise vernäht, ist.

14. Mehrschichtelement (1, 1') nach Anspruch 1, das mindestens eine elektrisch leitfähige Schicht, eine Schicht eines kathodischen elektrochromen Materials, welches geeignet ist, M⁺-Kationen des Typs H⁺ oder Li⁺ reversibel einzulagern, eine lithium- oder protonenleitende Elektrolytschicht, eine Gegenelektrodenschicht aus einem anodischen elektrochromen Material und eine zweite elektrisch leitfähige Schicht enthält, wobei besagte Struktur eine zwischen dem Elektrolyten und der Gegenelektrode angeordnete Barriereschicht aufweist, wobei die besagte Barriereschicht die Diffusion der M⁺-Kationen erlaubt und ein Material ausgewählt aus der Gruppe bestehend aus Nb₂O₅, CeF₃, Sb₂O₃, HUP, Cr₂O₃, ZrO₂, Li₃N, LiTaO₃, LiAlF₄, Li₃PO₄, LiBO₂ und LiNbO₃ ist.

15. Mehrschichtelement (1, 1') nach Anspruch 1 , das mindestens eine elektrisch leitfähige Schicht, eine Schicht eines kathodischen elektrochromen Materials, welches geeignet ist, M⁺-Kationen des Typs H⁺ oder Li⁺ reversibel einzulagern, eine lithium- oder protonenleitende Elektrolytschicht, eine Gegenelektrodenschicht aus einem anodischen elektrochromen Material und eine zweite elektrisch leitfähige Schicht enthält, wobei besagte Struktur eine zwischen dem Elektrolyten und der Gegenelektrode angeordnete Barriereschicht aufweist, wobei die besagte Barriereschicht die Diffusion der M⁺-Kationen erlaubt und eine Ta₂O₅-Schicht ist, die eine Dicke im Bereich von 1 bis 500 nm aufweist, und bevorzugt eine Ta₂O₅-Schicht ist, die eine Dicke im Bereich von 40 bis 120 nm aufweist.

## Revendications

1. Elément multicouche (1, 1') comprenant une première électrode de surface transparente (3), une couche fonctionnelle (4) et une électrode arrière plane (6), la première électrode de surface transparente (3) faisant saillie latéralement au-delà de la couche fonctionnelle (4) et de l'électrode arrière (6) et, dans une région (13) faisant saillie latéralement au-delà de l'électrode arrière (6), comportant un élément de connexion (17) permettant l'application d'une tension, dans lequel une seconde électrode de surface transparente (8), qui fait saillie latéralement au-delà de l'électrode arrière (6) et qui est connectée au moyen d'une couche adhésive diélectrique transparente (7) premièrement à l'électrode arrière (6) et, dans une région (13) faisant saillie au-delà de l'électrode arrière (6), deuxièmement à la première électrode de surface transparente (3), un élément de contact (22, 22', 22") qui pénètre à travers la couche adhésive transparente diélectrique (7) étant disposé entre l'électrode arrière (6) et la seconde électrode de surface transparente (8), ledit élément de contact connectant l'électrode arrière (6) et la seconde électrode de surface transparente (8) l'une à l'autre au moins indirectement, **caractérisé par le fait qu'**il y a situées sur les deux côtés de la couche adhésive diélectrique transparente (7) dans chaque cas premièrement une électrode arrière (6) et ensuite une couche fonctionnelle (4) et, contiguë à cette dernière, une première ou seconde électrode de surface transparente (3, 8), l'élément de contact (22) connectant électriquement les deux électrodes arrière (6) l'une à l'autre.

2. Elément multicouche selon la revendication 1, **caractérisé par le fait que** l'élément de contact (22, 22', 22") couple électriquement l'électrode arrière (6) à la seconde électrode de surface transparente (8).

3. Elément multicouche (1, 1') selon la revendication 1 ou 2, **caractérisé par le fait que** la première électrode de surface transparente (3) et/ou la seconde électrode de surface transparente (8) sont/est appliquée(s) à un substrat (2, 9), le/les substrat(s) dans chaque cas formant une couche externe de l'élément multicouche (1, 1').

4. Elément multicouche (1, 1') selon la revendication 3, **caractérisé par le fait qu'**au moins un substrat est composé de verre ou de matériau plastique transparent, en particulier de polycarbonate, ou d'un film plastique transparent, en particulier du poly(téréphtalate d'éthylène) (PET).

5. Elément multicouche (1, 1') selon l'une quelconque des revendications 1 à 4, **caractérisé par le fait que** l'élément fonctionnel (4) est un élément lumineux à électroluminescence, une couche électrochrome ou une couche contenant des cristaux liquides.

6. Elément multicouche (1, 1') selon la revendication 5, **caractérisé par le fait qu'**une couche d'isolant (5), de préférence composée de titanate de baryum (Ba-TiO₃), est située entre au moins un élément lumineux à électroluminescence et l'électrode arrière attribuée (6).

7. Elément multicouche (1, 1') selon l'une quelconque des revendications 1 à 6, **caractérisé par le fait que** l'élément de contact (22, 22', 22") est agencé avec une précontrainte dans la couche adhésive transparente diélectrique (7) de l'élément multicouche (1, 1') et, dans un état fini de l'élément multicouche (1, 1'), presse élastiquement contre les deux couches à connecter électriquement par contact.

8. Elément multicouche (1, 1') selon la revendication 7, **caractérisé par le fait que** l'élément de contact (22') est une pince métallique pliée d'une manière en forme de C, de préférence composée de métal en fil ou en feuille.

9. Elément multicouche (1, 1') selon la revendication 7, **caractérisé par le fait que** l'élément de contact (22") est une structure de fils tressés.

10. Elément multicouche (1, 1') selon la revendication 7 ou 9, **caractérisé par le fait que** l'élément de contact (22") possède une âme élastique (32), par exemple composée d'un matériau alvéolaire, et une gaine flexible conductrice (33) entourant ladite âme.

11. Elément multicouche (1, 1') selon l'une quelconque des revendications 7 à 10, **caractérisé par le fait que** l'élément de contact (22) est formé par un adhésif conducteur de l'électricité ou par un vernis-laque d'argent conducteur, l'adhésif ou le vernis-laque d'argent conducteur étant introduit dans un état liquide dans une perforation (25) dans la couche adhésive diélectrique (7) et, dans l'état fini de l'élément multicouche (1, 1'), étant durci et lié de manière cohésive aux couches à connecter électriquement.

12. Elément multicouche (1, 1') selon l'une quelconque des revendications 1 à 11, **caractérisé par le fait que** l'élément de contact (22) est transparent, et de préférence comprend un polymère transparent.

13. Elément multicouche (1, 1') selon la revendication 12, **caractérisé par le fait qu'**un film composé de polymère transparent comporte des fils conducteurs très minces, de préférence piqués.

14. Elément multicouche (1, 1') selon la revendication 1 comprenant au moins un film conducteur de l'électricité, un film d'un matériau électrochrome cathodique, qui est apte à insérer de manière réversible des cations M⁺ du type H⁺ ou Li⁺, un film d'électrolyte conducteur de lithium ou de protons, un film de contre-électrode réalisé en un matériau électrochrome anodique, et un second film conducteur de l'électricité, ladite structure ayant un film barrière interposé entre l'électrolyte et la contre-électrode, ledit film barrière permettant la diffusion des cations M⁺ et qui est une substance sélectionnée parmi le groupe constitué de Nb₂O₅, CeF₃, Sb₂O₃, HUP, Cr₂O₃, ZrO₂, Li₃N, LiTaO₃, LiAlF₄, Li₃PO₄, LiBO₂ et LiNbO₃.

15. Elément multicouche (1, 1') selon la revendication 1 comprenant au moins un film conducteur de l'électricité, un film d'un matériau électrochrome cathodique, qui est apte à insérer de manière réversible des cations M⁺ du type H⁺ ou Li⁺, un film d'électrolyte conducteur de lithium ou de protons, un film de contre-électrode réalisé en un matériau électrochrome anodique, et un second film conducteur de l'électricité, ladite structure ayant un film barrière interposé entre l'électrolyte et la contre-électrode, ledit film barrière permettant la diffusion des cations M⁺ et qui est une couche de Ta₂O₅ ayant une épaisseur s'étendant de 1 à 500 nm et qui est de préférence une couche de Ta₂O₅ ayant une épaisseur s'étendant de 40 à 120 nm.
